# FASCICULE DE BREVET EUROPEEN

(11) **EP 1 096 843 B1**
(45) Date de publication et mention de la délivrance du brevet: **24.05.2006**
(21) Numéro de dépôt: 00402899.9
(22) Date de dépôt: 19.10.2000
(51) Int. Cl.: H05K 7/04, H05K 7/20, B60R 16/02

(54) **Dispositif de commutation de puissance**
Leistungsumschaltvorrichtung
Power switching device

(30) Priorité: 28.10.1999 FR 9913527
(43) Date de publication de la demande: 02.05.2001
(73) Titulaire: DAV, 78180 Montigny le Bretonneux (FR)
(72) Inventeur: Deviller, Cécile, c/o Sylea, Vétraz-Monthoux, 74106 Annemasse Cédex (FR); Bitauld, Lionel, c/o Sylea, Vétraz-Monthoux, 74106 Annemasse Cédex (FR); Razurel, Guy, c/o Sylea, Vétraz-Monthoux, 74106 Annemasse Cédex (FR)
(74) Mandataire: Bertrand, Didier

(56) Documents cités:
- DE-A- 4 410 061
- DE-A- 19 518 522
- DE-C- 19 602 637
- DE-U- 8 317 699

## Description

La présente invention concerne un dispositif de commutation de puissance, notamment pour boîtiers d'interconnexion destinés aux véhicules automobiles.

En raison de nombreux équipements électriques et/ou électroniques utilisés dans l'industrie dans l'industrie automobile pour assurer des fonctions spécifiques de plus en plus nombreuses, il est nécessaire de transférer des puissances électriques qui sont variables suivant les fonctions souhaitées à partir d'une alimentation. Parmi les fonctions qui sont couramment utilisées, on peut citer la commande des lève-vitres électriques, la commande électrique des sièges, temporisation de l'éclairage de l'habitacle, etc... Le nombre de commutations étant croissant, il s'ensuit que les organes de commande tels que des commutateurs sont également croissants, ce qui entraîne une complexité des circuits utilisés. Or, l'espace réservé à toutes ces fonctions et à leur commande étant limité, il devient indispensable de réduire l'encombrement et, à cet effet, de réaliser des ensembles et/ou sous-ensembles les plus compacts possibles. Par ailleurs, se posent également les problèmes du transfert de puissances élevées pour certaines fonctions et de la dissipation thermique engendrée par les organes de puissance.

Des dispositifs susceptibles de donner satisfaction ont été proposés.

Pour commuter une puissance, on peut utiliser des relais qui sont enfichés sur des circuits de cuivre découpés. Une telle technique est de plus en plus abandonnée car elle nécessite un volume ou encombrement élevé et elle présente une mauvaise fiabilité en plus du bruit de commutation qu'elle produit.

Une deuxième technique consiste à souder les relais sur un circuit imprimé. Malheureusement, cela n'a pas amélioré la fiabilité même si on a réduit le volume.

Une troisième technique utilisée depuis l'apparition d'organes de commutation performants tels que ceux désignés par les termes MOSFET ou SMART POWER, a consisté à souder ces organes de commutation sur le circuit imprimé, de la même manière que dans la deuxième technique. Seulement, le remplacement des relais par des MOSFETS ou SMART POWER a engendré la création d'une plus grande énergie thermique qu'il est nécessaire d'évacuer ou de dissiper. Pour cela, on utilise des pistes ou plages de cuivre qui sont prévues dans le circuit imprimé ou un dissipateur thermique rapporté, pour assurer le refroidissement de l'ensemble. Un inconvénient majeur de cette technique est le coût élevé consécutif à un plus grand nombre d'éléments utilisés et une dissipation thermique qui n'est pas satisfaisante ou mal maîtrisée.

Une quatrième technique consiste à utiliser des ensembles dénommés SMI et qui sont constitués par un empilage d'une plaque d'aluminium, d'un isolant et d'un circuit imprimé. Le SMI est encore appelé substrat métallique isolé. Les MOSFETS ou SMART POWER sont soudés sur le circuit imprimé, la plaque d'aluminium étant utilisée uniquement pour dissiper la chaleur produite par les MOSFETS ou les SMART POWER (organes commutation). L'inconvénient majeur de cette technique réside dans le fait que les transferts de puissance et de commande sont effectués par le circuit imprimé qui doit être conçu spécialement pour assurer ces deux fonctions de transfert. De plus, l'isolation entre le circuit imprimé et la plaque d'aluminium étant réalisée par un isolant, il s'ensuit que le coût du dispositif de commutation est relativement élevé ce qui peut être un facteur (critère) négatif surtout dans l'industrie automobile dans laquelle on utilise un grand nombre de ces dispositifs.

La présente invention a pour but de proposer un dispositif qui est capable de commuter des puissances électriques importantes sans avoir recours à des dissipateurs thermiques supplémentaires.

La présente invention a pour objet un dispositif de commutation de puissance électrique, du type comprenant :
- des organes de commutation,
- des moyens de transfert de puissance électrique,
- des moyens de dissipation thermique,
- un moyen de commande et de protection des organes de commande
caractérisé en ce que les moyens de transfert de puissance électrique et de dissipation thermique sont constitués par une plaque métallique découpée qui est disposée sur un élément isolant et sur laquelle sont montés les organes de commutation, des broches de connexion issues de ladite plaque métallique assurant une liaison avec le moyen de commande et de protection des organes de commutation.

Un avantage de la présente invention réside dans le fait que le dispositif de commutation est très compact car il ne fait pas appel à des éléments supplémentaires spécifiques capables d'assurer telle ou telle fonction souhaitée. C'est ainsi que la plaque métallique, par exemple en cuivre qui est découpée et sur laquelle sont brasés les organes de commutation tels que les MOSFETS, assure une bonne dissipation thermique et offre une faible résistance électrique au passage du courant de la charge commutée par les MOSFETS.

De plus, la plaque de cuivre découpée permet de réduire très considérablement la résistance électrique au passage du courant de la charge commutée par chacun des MOSFETS.

Une autre caractéristique de la présente invention est que la commande et la protection de chaque MOSFET sont assurées par une électronique prévue sur un circuit imprimé, les liaisons entre l'électronique et chaque MOSFET étant réalisées par des découpes du circuit de cuivre.

D'autres avantages et caractéristiques apparaîtront à la lecture de la description d'un mode de réalisation de l'invention, ainsi que des dessins annexés sur lesquels :
- la figure 1 est une vue partielle en perspective du dispositif selon l'invention ;
- la figure 2 est une vue en perspective analogue à celle de la figure 1, le dispositif étant complété par une plaque de circuit imprimé ;

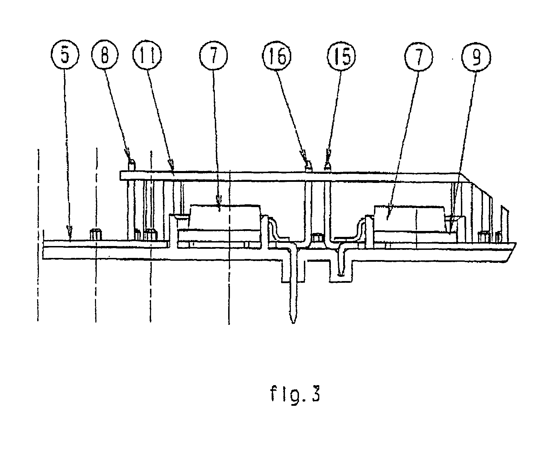

- la figure 3 est une vue en coupe du dispositif au niveau des MOSFETS ;

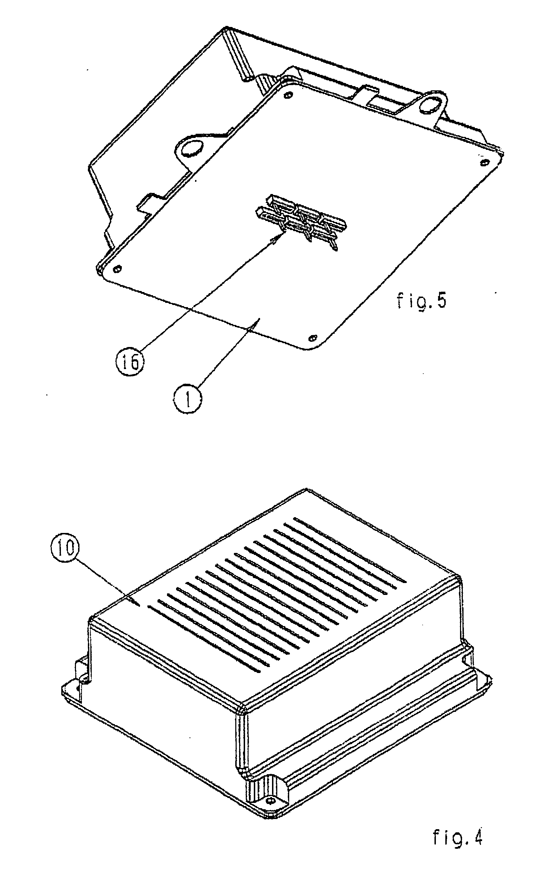

- les figures 4 et 5 sont des vues en perspective du dispositif disposé dans un capot de fermeture et de protection.

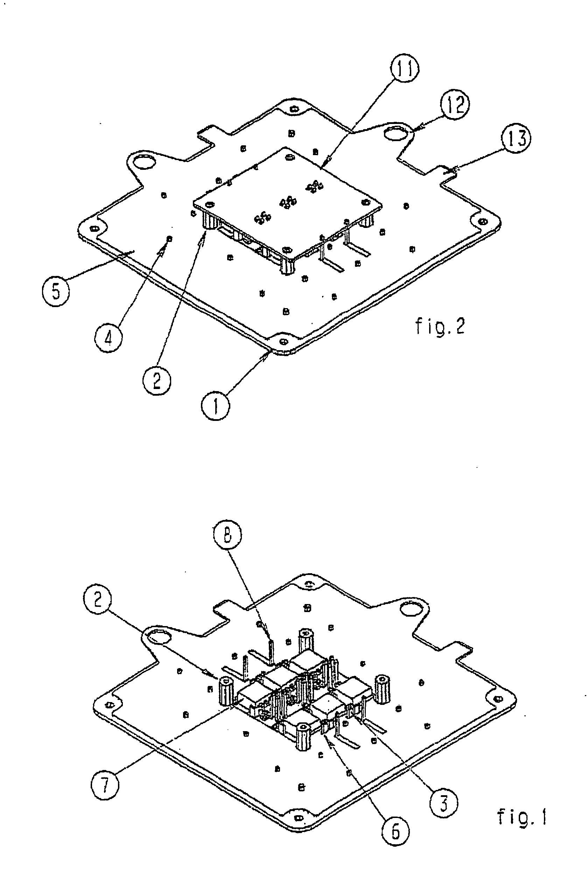

Le dispositif représenté sur les figures 1 et 2 comprend un support inférieur plastique 1 qui peut comprendre des parois de positionnement 2 d'un circuit imprimé, des guides 3 pour des organes de commutation dénommés MOSFETS par les spécialistes, de tels MOSFETS étant du type de ceux commercialisés par la Société THOMSON-ELECTRONICS sous la référence STB60NE06-16. Un MOSFET comprend une ou deux bornes drains, une borne source et une borne grille. Des tétons de sertissage 4 sont également prévus sur la plaque support plastique 1.

Une plaque métallique, par exemple en cuivre, d'épaisseur supérieure à 0,4 mm, prédécoupée et pliée 5, est montée sur le support en plastique 1 et elle est sertie sur ce dernier au moyen des tétons de sertissage 4. Dans un autre mode de réalisation la plaque ou circuit cuivre 5 peut être surmoulé pour assurer l'isolation de sa face inférieure. Des découpes 6 sont ménagées sur la plaque de cuivre 5 pour permettre le passage des guides 3 pour les MOSFETS 7 et pour un circuit imprimé 11 qui constitue un moyen de commande et de protection des MOSFETS.

La plaque de cuivre 5 est munie d'un moyen de raccordement à une alimentation par l'intermédiaire d'une languette 13 ou d'une partie latérale 12 munie d'un trou permettant le passage d'une vis.

Les drains 9 des MOSFETS sont reliés électriquement et thermiquement, par exemple par brasure, directement sur la plaque de cuivre 5. La liaison entre le drain 9 des MOSFETS et le circuit imprimé 11 est réalisé par des broches de connexion 8 issues de la plaque de cuivre 5.

Dans l'exemple représenté sur la figure 1, le dispositif comprend six MOSFETS 7 dont l'alimentation est commune et assurée par la plaque de cuivre 5 sur laquelle sont brasés les drains 9 des MOSFETS. L'équipotentialité ainsi réalisée est transmise à l'électronique de commande du circuit imprimé par les broches 8 qui sont de préférence prédécoupées en bande sur la plaque de cuivre 5 mais qui pourraient être rapportées sur le support plastique 1.

La grille des MOSFETS est brasée sur une broche 15 au niveau d'une partie plate. L'autre partie de cette broche 15 en forme de picot permet la liaison au circuit imprimé 11.

La source des MOSFETS est également brasée sur une broche 16 qui réalise la même fonction que la broche précédente 15 et qui permet en plus le raccordement du faisceau des câbles sous la forme d'une fiche de connectique standard 16.

Les picots drain, source et grille sont soudés sur le circuit imprimé, lequel est équipé de composants qui permettent de réaliser la commande et la protection des organes de commande. Il est à noter que la protection ainsi réalisée est réarmable.

La liaison des MOSFETS, par ses divers drains, grille et source, avec la plaque de cuivre 5 et les broches 15 et 16 peut être effectuée au moyen d'une colle électriquement et thermiquement conductrice.

La plaque ou circuit en cuivre 5 assure une bonne dissipation de l'échauffement produit par les MOSFETS tout en offrant une faible résistance électrique au passage du courant de la charge commutée par les MOSFETS.

De manière à optimiser la dissipation thermique des MOSFETS vers l'extérieur, on utilise un support plastique isolant 1 qui soit le plus proche possible de la plaque de cuivre 5, sans élément intermédiaire entre le support isolant 1 et la plaque de cuivre 5. Dans l'exemple de réalisation représenté sur les figures 1 et 2, le support isolant plastique 1 a une épaisseur comprise entre 0,5 et 1,5 mm.

Grâce à la présente invention, il est possible de passer davantage de puissance par la plaque de cuivre, comparée à ce qui est possible avec les dispositifs de l'art antérieur et ce, tout en assurant une dissipation thermique particulièrement efficace.

Dans ce qui précède, on s'est référé à des organes de commutation du type MOSFET, mais il va de soi qu'on peut utiliser d'autres composants de puissance de technologie différente tels que les composants de puissance bipolaires.

De même, on peut substituer à la plaque de cuivre une plaque réalisée dans une autre matière conductrice dont les propriétés thermique et électrique sont similaires à celle du cuivre.

L'ensemble précédemment décrit est protégé par un capot de protection 10.

## Revendications

1. Dispositif de commutation de puissance électrique, du type comprenant :
- des organes de commutation (7),
- des moyens de transfert de puissance électrique,
- des moyens de dissipation thermique,
- un moyen de commande et de protection des organes de commutation (7),
**caractérisé en ce que** les moyens de transfert de puissance électrique et de dissipation thermique sont constitués par une plaque métallique (5) découpée qui est disposée sur un élément isolant (1) et sur laquelle sont montés les organes de commutation (7), des broches de connexion (8) issues de ladite plaque métallique (5) assurant une liaison avec le moyen de commande et de protection (11) des organes de commutation (7).

2. Dispositif selon la revendication 1, **caractérisé en ce que** chaque organe de commutation est constitué par un MOSFET dont la grille est reliée à une partie d'une broche (15), l'autre partie de ladite broche assurant une liaison avec ledit moyen de commande et de protection.

3. Dispositif selon la revendication 2, **caractérisé en ce que** la source de chaque MOSFET est reliée à une broche (16) qui assure une liaison avec ledit moyen de commande et de protection et un raccordement d'un faisceau de câbles.

4. Dispositif selon l'une des revendications 1 à 3, **caractérisé en ce que** les organes de commutation (7) sont brasés sur la plaque métallique (5).

5. Dispositif selon l'une des revendications 1 à 3, **caractérisé en ce que** les organes de commutation (7) sont collés au moyen d'une colle conductrice électriquement et thermiquement sur la plaque métallique (7) aux endroits appropriés.

6. Dispositif selon l'une des revendications précédentes, **caractérisé en ce que** la plaque métallique (5) est en cuivre et d'épaisseur supérieure à 0,4 mm.

7. Dispositif selon la revendication 1, **caractérisé en ce que** le moyen de commande et de protection des organes de commutation est constitué par un circuit imprimé (11).

8. Dispositif selon la revendication 1, **caractérisé en ce que** la plaque de cuivre (5) est dotée d'organes de raccordement (12, 13) à une alimentation électrique.

9. Dispositif selon la revendication 8, **caractérisé en ce qu'**au moins un des organes de raccordement est constitué par une languette de connexion (12).

10. Dispositif selon la revendication 1, **caractérisé en ce qu'**il est logé dans un capot de protection (10).

## Claims

1. Electric power switching device, of the type comprising:
- switching members (7);
- electric power transfer means;
- heat dissipation means; and
- a means for controlling and protecting the switching members (7),
**characterized in that** the electric power transfer means and the heat dissipation means are formed by a cut metal plate (5) that is placed on an insulating element (1) and mounted on said metal plate are the switching members (7), connection pins (8) emanating from said metal plate (5) providing connection with the means (11) for controlling and protecting the switching members (7).

2. Device according to Claim 1, **characterized in that** each switching member is formed by a MOSFET, the gate of which is connected to one part of a pin (15), the other part of said pin providing connection with said control and protection means.

3. Device according to Claim 2, **characterized in that** the source of each MOSFET is connected to a pin (16), which provides connection with said control and protection means and connection to a cable bundle.

4. Device according to one of Claims 1 to 3, **characterized in that** the switching members (7) are soldered to the metal plate (5).

5. Device according to one of Claims 1 to 3, **characterized in that** the switching members (7) are bonded by means of an electrically and thermally conductive adhesive to the metal plate (7) at the appropriate places.

6. Device according to one of the preceding claims, **characterized in that** the metal plate (5) is made of copper and has a thickness of greater than 0.4 mm.

7. Device according to Claim 1, **characterized in that** the means for controlling and protecting the switching members is formed by a printed circuit (11).

8. Device according to Claim 1, **characterized in that** the copper plate (5) is furnished with connection members (12, 13) for connection to a power supply.

9. Device according to Claim 8, **characterized in that** at least one of the connection members is formed by a connection tab (12).

10. Device according to Claim 1, **characterized in that** it is housed in a protective cover (10).

## Patentansprüche

1. Vorrichtung zum Umschalten elektrischer Leistung des Typs, der umfasst:
- Schaltorgane (7),
- Mittel zum Übertragen elektrischer Leistung,
- Mittel zur Wärmeabführung,
- ein Mittel zum Steuern und Schützen der Schaltorgane (7),
**dadurch gekennzeichnet, dass** die Mittel zum Übertragen elektrischer Leistung und die Mittel zur Wärmeabführung durch eine zugeschnittene metallische Platte (5) gebildet sind, die auf einem isolierenden Element (1) angeordnet ist und auf der die Schaltorgane (7) montiert sind, wobei Anschlussstifte (8), die von der metallischen Platte (5) abstehen, eine Verbindung mit dem Mittel (11) zum Steuern und Schützen der Schaltorgane (7) gewährleisten.

2. Vorrichtung nach Anspruch 1, **dadurch gekennzeichnet, dass** jedes Schaltorgan durch einen MOSFET gebildet ist, dessen Gate mit einem Teil eines Stifts (15) verbunden ist, wobei der andere Teil dieses Stifts eine Verbindung mit den Steuerungs- und Schutzmitteln gewährleistet.

3. Vorrichtung nach Anspruch 2, **dadurch gekennzeichnet, dass** die Söurce jedes MOSFET mit einem Stift (16) verbunden ist, der eine Verbindung mit dem Steuerungs- und Schutzmittel sowie eine Verbindung mit einem Kabelbündel gewährleistet.

4. Vorrichtung nach einem der Ansprüche 1 bis 3, **dadurch gekennzeichnet, dass** die Schaltorgane (7) auf die metallische Platte (5) gelötet sind.

5. Vorrichtung nach einem der Ansprüche 1 bis 3, **dadurch gekennzeichnet, dass** die Schaltorgane (7) mittels eines elektrisch und thermisch leitenden Klebstoffs an geeigneten Stellen auf die metallische Platte (7) geklebt sind.

6. Vorrichtung nach einem der vorhergehenden Ansprüche, **dadurch gekennzeichnet, dass** die metallische Platte (5) aus Kupfer besteht und eine Dicke besitzt, die größer als 0,4 mm ist.

7. Vorrichtung nach Anspruch 1, **dadurch gekennzeichnet, dass** das Mittel zum Steuern und Schützen der Schaltorgane durch eine gedruckte Schaltung (11) gebildet ist.

8. Vorrichtung nach Anspruch 1, **dadurch gekennzeichnet, dass** die Kupferplatte (5) mit Organen (12, 13) für die Verbindung mit einer elektrischen Versorgung versehen ist.

9. Vorrichtung nach Anspruch 8, **dadurch gekennzeichnet, dass** wenigstens eines der Verbindungsorgane durch eine Anschlusszunge (12) gebildet ist.

10. Vorrichtung nach Anspruch 1, **dadurch gekennzeichnet, dass** sie sich in einer Schutzhaube (10) befindet.
